# FASCICULE DE BREVET EUROPEEN

(11) **EP 2 730 025 B1**
(45) Date de publication et mention de la délivrance du brevet: **09.09.2015**
(21) Numéro de dépôt: 12735502.2
(22) Date de dépôt: 06.07.2012
(51) Int. Cl.: H03H 9/02, H03H 9/24, H03H 9/17, B06B 1/02

(54) **RÉSONATEUR À ONDES DE VOLUME EXPLOITANT L'EXCITATION/DÉTECTION DE LA VIBRATION**
VOLUMENWELLENRESONATOR MIT SCHWINGUNGSERREGUNG/-ERFASSUNG
VOLUME WAVE RESONATOR USING EXCITATION/DETECTION OF VIBRATIONS

(30) Priorité: 08.07.2011 FR 1156250
(43) Date de publication de la demande: 14.05.2014
(73) Titulaire: Centre National de la Recherche Scientifique (CNRS), 75016 Paris (FR); Université de Franche-Comté, 25030 Besançon Cedex (FR)
(72) Inventeur: DULMET, Bernard, F-25000 Besançon (FR); IVAN, Mihaela, F-25000 Besançon (FR); BALLANDRAS, Sylvain, F-25000 Besançon (FR)
(74) Mandataire: Domenego, Bertrand
(86) Numéro de dépôt international: PCT/EP2012/063300
(87) Numéro de publication internationale: WO 2013/007652

(56) Documents cités:
- EP-A1- 1 610 459
- US-A1- 2009 001 853
- US-A1- 2009 108 381
- EYOURN M-A ET AL: "Analysis and modeling of curvature in copper-based mems structures fabricated using cmos interconnect technology", SOLID-STATE SENSORS, ACTUATORS AND MICROSYSTEMS, 2005. DIGEST OF TECHN ICAL PAPERS. TRANSDUCERS '05. THE 13TH INTERNATIONAL CONFERENCE ON SEOUL, KOREA JUNE 5-9, 2005, PISCATAWAY, NJ, USA,IEEE, vol. 1, 5 juin 2005 (2005-06-05), pages 764-767, XP010828268, DOI: 10.1109/SENSOR.2005.1496529 ISBN: 978-0-7803-8994-6
- Hariklia Deligianni ET AL: "MEMS Fabrications for Wireless Communications Using Copper Interconnect Technology", IBM Research Report RC23547, 28 février 2005 (2005-02-28), pages 1-13, XP055017974, Yorktown Heights Extrait de l'Internet: URL:http://www.memsinfo.jp/whitepaper/rc23 547-1.pdf [extrait le 2012-01-31]
- JAHNES C V ET AL: "Simultaneous fabrication of RF MEMS switches and resonators using copper-based CMOS interconnect manufacturing methods", MICRO ELECTRO MECHANICAL SYSTEMS, 2004. 17TH IEEE INTERNATIONAL CONFER ENCE ON. (MEMS) MAASTRICHT, NETHERLANDS 25-29 JAN. 2004, PISCATAWAY, NJ, USA,IEEE, US, 25 janvier 2004 (2004-01-25), pages 789-792, XP010768009, DOI: 10.1109/MEMS.2004.1290703 ISBN: 978-0-7803-8265-7

## Description

La présente invention concerne un résonateur à ondes acoustiques de volume configuré pour résonner à une fréquence de travail prédéterminée comprenant :
- un support, comprenant une première face et une deuxième face, constitué par une couche d'une première épaisseur s₁ d'un premier matériau isolant acoustiquement et électriquement,
- un substrat résonnant, comprenant une première face et une deuxième face, constitué par au moins une couche d'une deuxième épaisseur t₁ d'un second matériau acoustiquement résonnant, et
- une membrane constituée par une couche d'une troisième épaisseur d'un troisième matériau, la membrane reliant rigidement, d'une part, la deuxième face face du support et, d'autre part, la première face du substrat résonnant.

Des microsystèmes électromécaniques (« MicroElectroMechanical System » ou MEMS en anglais) résonants sont connus.

On connaît ainsi la famille des résonateurs dont l'élément résonant est déformé selon une direction transversale à la direction de propagation de l'onde.

Par exemple, le document US 2009/108381 A1 divulgue un résonateur dont l'élément résonant est une poutre située dans une cavité et dont les deux extrémités sont fixées à des plots de support. La face inférieure de la poutre porte une première électrode. En vis-à-vis de celle-ci, une seconde électrode est prévue sur la paroi inférieure de la cavité, entre les plots de support de la poutre. La variation de la différence de potentiel entre les première et seconde électrodes génère une force électrostatique propre à faire osciller la poutre.

On connaît également la famille des résonateurs dont l'élément résonant est déformé selon une direction parallèle à la direction de propagation de l'onde.

Par exemple, l'article de V. Kaajakari et al. "Square-Extensional Mode Single-Crystal Silicon Micromechanical RF-resonator" in "the 12th International Conférence on Solid State Sensors, Actuators and Microsystems (Boston - 2003)" publié par IEEE décrit l'utilisation d'une plaque carrée en tant qu'élément résonant, la plaque étant déformée dans sa longueur et dans sa largeur.

De tels résonateurs, dits « à ondes acoustiques de volume », présentent l'avantage de fonctionner avec des fréquences d'utilisation élevées. Ils comportent toujours un transducteur constitué d'un matériau piézoélectrique.

En particulier, dans la famille des résonateurs à ondes acoustiques de volume, les résonateurs de type FBAR, acronyme de Film Bulk Acoustic Resonator, présentent l'avantage d'obtenir des résonateurs à fort facteur de qualité et d'avoir une bonne co-intégration avec un circuit monolithique. Ces résonateurs à excitation piézoélectrique sont communément utilisés pour la conception d'oscillateurs électriques, de filtres ou encore de capteurs.

Dans le but d'accéder à des structures plus variées en termes de matériaux et de s'affranchir même de l'utilisation d'un matériau piézoélectrique, un mode d'excitation électrostatique a été étudié de manière générique et est décrit par A. Reinhardt dans la thèse de doctorat de l'Université de Franche Comté 2005, intitulée « simulation, conception et réalisation de filtres à ondes de volume dans des couches minces piézoélectriques ».

Dans ce document, il est décrit un résonateur à excitation électrostatique comprenant un film mince, non nécessairement piézoélectrique, métallisé sur ses deux faces par deux électrodes, en vis-à-vis desquelles ont été placé de part et d'autre deux contre-électrodes solidaires d'un même bâti, de sorte que deux entrefers sont formés par les couples électrode/contre-électrode.

Un champ électrique est généré par application d'une différence de potentiel harmonique entre les électrodes et les contre-électrodes.

La force électrostatique générée dans les deux entrefers attire les électrodes vers les contre-électrodes, causant l'étirement du film dans son épaisseur. Comme les forces électrostatiques sont toujours attractives, l'excitation directe de champs mécaniques oscillants n'est pas possible. Il est nécessaire de polariser tout d'abord le résonateur par application d'une tension continue, puis on lui applique en même temps une tension alternative qui vient augmenter ou relâcher la force d'attraction que subit le film.

Dans cette configuration, il y a échange entre le mode électrostatique existant dans l'entrefer et le mode mécanique excité dans la membrane.

Pour ce résonateur, le coefficient de couplage dépend à la fois de l'élasticité du matériau, de la géométrie considérée et de la polarisation appliquée.

Toutefois, il faut considérer que la résistance mécanique du matériau du film impose une limite aux déformations que peut subir le film et un défaut de symétrie de la force électrostatique risque de détruire le film. Par ailleurs, le claquage de l'entrefer est une cause courante de destruction du film. Ainsi, la valeur du potentiel de polarisation est limitée pour éviter toute destruction.

Le couplage croît avec la polarisation du résonateur et décroît avec la largeur de l'entrefer.

Il est difficile de maximiser le coefficient de couplage. Par exemple, pour une membrane de 1 µm de silicium, polarisée avec une tension de 40 Volts, un entrefer de seulement 10 nm est nécessaire pour obtenir un coefficient de couplage comparable avec ceux que l'on obtient par excitation piézoélectrique. Et la dépendance à l'ordre 3 de ce paramètre fait qu'en choisissant une dimension de l'entrefer à peine supérieure, le coefficient de couplage chute déjà beaucoup si l'on n'augmente pas la tension de polarisation en parallèle, ce qui toutefois accélère les risques de rupture de la membrane.

Ainsi, ce principe d'excitation électrostatique a été jugé inapplicable car les calculs montrent un coefficient de couplage électromécanique quasiment nul.

Le but de l'invention est donc d'améliorer le couplage électromécanique associé à un mode d'excitation d'ondes acoustiques de volume dans tous types de matériaux, pour une application de résonateur.

A cet effet, l'invention a pour objet un résonateur à ondes acoustiques de volume, un procédé de fabrication d'un tel résonateur et un composant électronique comprenant un tel résonateur conformes aux revendications.

Ces caractéristiques et avantages de l'invention apparaîtront à la lecture de la description qui va suivre, donnée uniquement à titre d'exemple non limitatif, et faite en référence aux dessins annexés, sur lesquels :
- la Figure 1 est une représentation schématique d'un résonateur à ondes acoustiques de volume selon l'invention,
- la Figure 2 est une représentation schématique d'un résonateur comprenant un dispositif d'excitation/détection selon un premier mode de réalisation,
- la Figure 3 est une représentation schématique d'un résonateur comprenant un dispositif d'excitation/détection selon un second mode de réalisation,
- la Figure 4 est un organigramme d'un procédé de réalisation d'un résonateur selon l'invention,
- la Figure 5 est un schéma d'un dispositif de compensation de la capacité statique du résonateur par self,
- la Figure 6 est un schéma d'un dispositif de compensation de la capacité statique de résonateur par transformateur, et
- la Figure 7 est un diagramme représentant la réponse électrique en fonction de la tension de polarisation d'un résonateur selon l'invention.

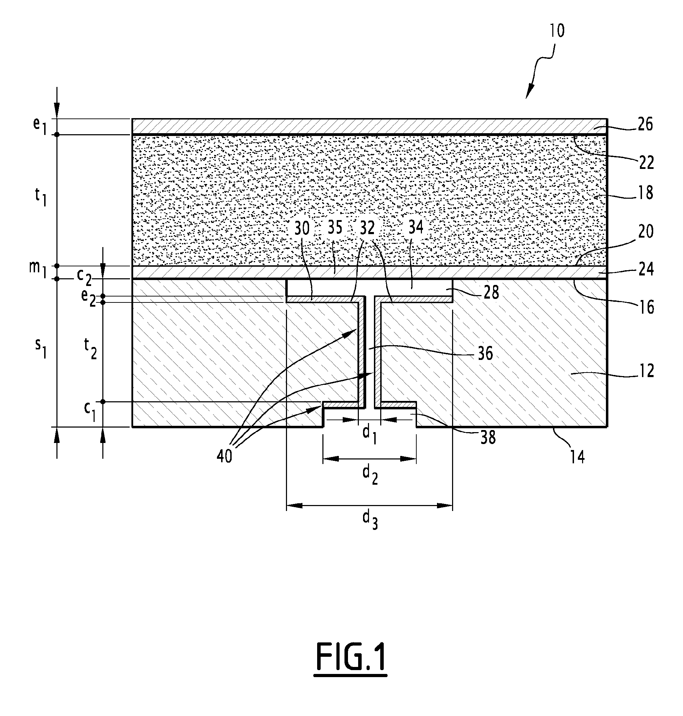

La Figure 1 représente un mode de réalisation d'un résonateur 10 à ondes de volume selon l'invention.

Le résonateur 10 comprend un empilement de couches successives comportant :
- un support 12, comprenant une première face 14 et une deuxième face 16, constitué par une couche d'une première épaisseur s₁ d'un premier matériau isolant acoustiquement et isolant électriquement, par exemple du verre,
- un substrat résonnant 18, comprenant une première face 20 et une deuxième face 22, constitué par une couche d'une deuxième épaisseur t₁ d'un second matériau acoustiquement résonnant, par exemple du silicium dopé conducteur
- une membrane 24 constituée par une couche d'une troisième épaisseur m₁ d'un troisième matériau, par exemple un matériau électriquement isolant comme de la silice, cette membrane 24 reliant rigidement, tout au moins dans une région inerte acoustiquement, d'une part la deuxième face 16 du support 12 et d'autre part la première face 20 du substrat résonnant 18, et
- une électrode externe 26 métallique, disposée sur la deuxième face 22 du substrat résonnant 18 et constituée par une première couche de métal d'une épaisseur e₁, par exemple de l'aluminium.

Le support 12 comporte, en outre, une cavité interne 28, débouchant sur la deuxième face 16 du support 12 et ayant une face de plancher 30 située en retrait dans le sens de l'épaisseur du support 12 par rapport à la deuxième face 16 du support 12.

Le support 12 comporte également une électrode interne 32, plane et métallique, formée par une seconde couche de métal, par exemple de l'or, et déposée sur la face de plancher 30.

Ainsi une zone d'entrefer 34 fermée est formée entre l'électrode interne 32 et la portion 35 de la membrane 24, disposée en vis-à-vis et recouvrant la cavité interne 28.

Plus précisément, la zone d'entrefer 34 est délimitée d'une part par l'interface du substrat résonnant 18 et la membrane 24, c'est-à-dire la première face 20 du substrat résonnant 18, et d'autre part par l'électrode interne 32.

Le substrat résonnant 18 est configuré par le choix de son épaisseur t1 pour obtenir une résonance du système d'ondes acoustiques à mode longitudinal générées entre sa première face 20 et sa deuxième face 22 lorsqu'un champ électrostatique ayant une composante sinusoïdale à la fréquence de travail est généré dans la zone d'entrefer 34 en conséquence de l'application d'une tension différentielle entre l'électrode externe 26 et l'electrode interne 32.

Comme représenté sur la Figure 1, le support 12 comporte un via traversant 36 reliant la cavité interne 28 à une ouverture externe 38 percée du côté de la première face 14 du support 12.

L'ouverture externe 38 présente une profondeur c₁ et un diamètre d₂, la cavité interne 28 présente une profondeur c₂ et un diamètre d₃.

Le via traversant 36 a ici la forme d'un cylindre de diamètre d₁, et de longueur t₂.

Une piste métallique 40 est déposée sur une surface interne du via traversant 36 et recouvre également un fond de l'ouverture externe 38 de façon à permettre la connexion de l'électrode interne 32 à un dispositif d'excitation/détection électrique.

De manière préférée, l'ouverture externe 38 a une section transversale de forme carrée.

L'épaisseur e₁ de l'électrode externe 26 est entre 100 et 500 nm, de préférence égale à 200 nm.

L'épaisseur t₁ du substrat résonnant 18 est comprise entre 200 et 500 µm, de préférence entre 300 et 400 µm, notamment égal à 380 µm.

L'épaisseur m₁ de la membrane 24 est inférieure à 600 nm, de préférence égale à 300 nm.

L'épaisseur s₁ du support 12 est égale à environ 1 mm.

La cavité interne 28 a une profondeur c₂ entre 500 et 1500 nm, de préférence égale à 1000 nm et un diamètre d₃ de 10 mm.

L'ouverture externe 38 a une profondeur c₁ de 100 µm et une largeur d₂ de 5 mm environ, et le via traversant 36 a un diamètre d₁ de 1 mm et une longueur t₂ de 900 µm environ.

L'épaisseur e₂ de l'électrode interne 32 est d'environ 250 nm, de sorte que l'entrefer 34, appelé en anglais « gap », présente une hauteur de préférence égale à 1000 nm.

Il est à remarquer que dans la Figure 1, la zone d'entrefer 34 est remplie d'air mais, en variante, il peut être rempli de vide ou par un autre gaz formant un diélectrique. Dans le cas où l'entrefer 34 est rempli d'un gaz sous pression il est nécessaire que le via 36 serve également de conduit d'échappement pour le gaz.

De manière avantageuse, le matériau du substrat résonnant 18 est un matériau monocristallin propre à l'obtention d'un facteur de qualité optimisé du fait de coefficients de frottement viscoélastique meilleurs que des matériaux amorphes.

Il est à remarquer que la disposition de l'électrode externe 26 sur la deuxième face 22 du substrat résonnant 18 est optionnelle. Elle sert d'électrode de masse et de piège pour les vibrations. Pour cela, elle est avantageusement ajourée, les différents jours ayant une forme et une superficie similaires à celles de l'électrode 32.

L'électrode 26 permet également de souder un fil de connexion électrique externe au résonateur 10, une connexion électrique directe au matériau du substrat 18, comme le Silicium, étant difficilement réalisable.

En variante, une piste d'alimentation disposée sur au moins une extrémité latérale de la membrane 24, à gauche ou à droite sur la Figure 1, est possible pour raccorder la membrane 24 à un dispositif d'excitation externe.

Ici, la disposition de l'électrode externe 26 sur la deuxième face 22 libre du substrat résonnant 18, c'est-à-dire ici du silicium dopé, facilite la connexion électrique de la face 20, délimitant la zone d'entrefer, à un dispositif d'excitation externe du résonateur (non représenté sur la Figure 1).

Dans le cas où le matériau du substrat résonnant 18 est un isolant électrique, la membrane 24 sera constitué d'un matériau conducteur, par exemple du métal, et il faudra prévoir un élément de connexion électrique entre cette membrane 24 et l'électrode externe 26, comme par exemple une piste de connexion électrique, c'est à dire un via traversant le substrat résonnant dans le sens de l'épaisseur. Alternativement, un retour de métallisation ou un usinage dégageant l'accès à la membrane 24 pourra être pratiqué.

Le fonctionnement du résonateur à ondes de volume illustré sur la Figure 1, va être à présent décrit.

Une tension électrique différentielle continue de niveau élevé, c'est-à-dire supérieure à 20 Volts et pouvant aller jusqu'à 300 Volts est appliquée entre la membrane 24 formant électrode et l'électrode interne 32.

La tension électrique différentielle continue, encore appelée tension de polarisation de la zone d'entrefer 34, est nécessaire pour permettre l'excitation directe de champs mécaniques oscillants au sein du substrat résonnant 18.

En effet, la force électrostatique générée dans la zone d'entrefer 34 attire toujours la face 20 du substrat résonnant 18 vers l'électrode interne 32, causant l'étirement du substrat résonnant 18 dans le sens de l'épaisseur. En conséquence, une pré-tension du substrat résonnant 18 est requise et est créée par l'application de la tension différentielle continue de niveau élevée.

En même temps que l'application du signal de tension différentielle continu de niveau élevé, un signal sinusoïdal de tension, de niveau faible par rapport au niveau du signal de tension continu dans un rapport voisin de 20 est appliqué entre l'électrode externe 26 et l'électrode interne 32. La membrane 24 devant être conductrice dans le cas d'un substrat résonnant isolant, elle peut éventuellement être utilisée directement à cet effet à la place de l'électrode externe 26 si elle n'est pas reliée électriquement à cette dernière.

La tension alternative vient ainsi augmenter ou relâcher la force d'attraction électrostatique que subit le substrat résonnant 18 dans la zone d'entrefer 34 couverte par la portion 35 de la membrane 24.

La force électrostatique générée est normale à la surface du substrat résonnant 18, de sorte que, à la fréquence de travail, par exemple de 10,3 MHz, seules des ondes acoustiques de volume à mode purement longitudinales sont excitées.

Cette force électrostatique génère alors des ondes de volume au sein du substrat résonnant 18 par excitation électrostatique, ce qui correspond à des vibrations du substrat résonnant 18.

Du fait que l'épaisseur t₁ du substrat résonnant 18 est déterminée de manière à produire par résonance des ondes acoustiques de volume longitudinales au sein du substrat résonnant 18 à la fréquence de travail du résonateur, un couplage élevé est créé entre le mode électrostatique dans l'entrefer 34 et le mode mécanique dans le substrat résonnant 18 consistant en une extension-compression de l'épaisseur de ce substrat.

Le coefficient de couplage du résonateur 10 dépend à la fois de l'élasticité du matériau du substrat résonnant 18, de la géométrie considérée et de la tension différentielle de polarisation appliquée.

De manière plus précise, l'épaisseur t₁ est calculée de sorte que l'onde acoustique est réfléchie en phase par les faces du substrat résonnant 18 de manière à interférer constructivement.

De plus, l'épaisseur t₁ du substrat résonnant 18 est supérieure à une épaisseur critique structurelle pour éviter toute vibration structurelle telle qu'une flexion du substrat résonnant 18 dans la région de la cavité interne 28.

En raison de la présence de la cavité interne 28 à diamètre d₃ limité et de l'épaisseur t₁ élevée du substrat résonnant un rapport t₁/d₃ plus élevé entre l'épaisseur t₁ du substrat 18 et le diamètre d₃ de la cavité interne 28 est obtenu en comparaison avec un film résonnant mince.

Ainsi, le seuil de la force électrostatique au-delà duquel la structure risque d'être détruite est plus élevé. Le niveau de déformation admissible que peut subir le substrat résonnant 18 avant qu'il ne soit détruit est alors plus élevé. Le niveau de la tension de polarisation ainsi que la hauteur c2 de l'entrefer permis sont également plus élevés.

D'autre part, le seuil de claquage du condensateur, constitué par la zone d'entrefer 34 et les surfaces conductrices qui le délimitent, est également amélioré d'au moins un facteur deux grâce à la couche de Silice isolante de la membrane 24 qui réduit le risque d'amorçage d'un arc électrique détruisant ce condensateur, permettant ainsi de pouvoir appliquer des niveaux de tension de polarisation plus élevés.

Ainsi, le couplage entre le mode électrostatique existant dans l'entrefer et le mode mécanique excité dans la membrane 24 est augmenté. Plus précisément, la passivation repousse le seuil de claquage et permet d'avoir une tension de polarisation plus élevée, ce qui est favorable à un bon couplage. Cependant, la présence de cette couche de Silice de passivation diminue le champ dans le « gap » et, par conséquent, le couplage. Un compromis doit donc être trouvé.

Dans le mode de réalisation représenté sur la Figure 1, une seule électrode interne 32 est utilisée pour l'excitation des ondes de volume, ce qui correspond à un mode d'excitation mono-port.

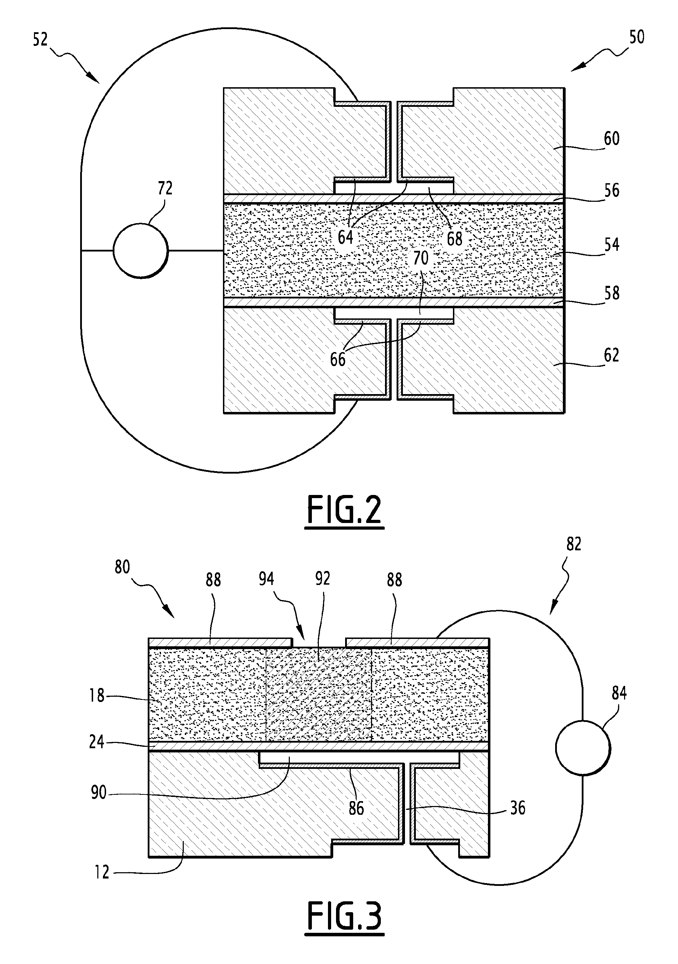

En variante du résonateur 10 de la Figure 1, comme illustrée sur la Figure 2, un résonateur 50 comporte un dispositif d'excitation/détection électrique 52 à mode d'excitation double port. Dans cet exemple de réalisation, le résonateur 50 comprend un substrat résonnant 54 à deux faces sur lesquelles sont collées deux membranes 56, 58. Deux supports 60, 62, comprenant chacun une électrode interne 64, 66, sont collés respectivement sur chaque membrane 56, 58.

Chaque électrode interne 64, 66, de manière similaire à l'électrode interne 32 du résonateur 10 de la Figure 1, est déposée dans une cavité interne différente associée au substrat résonnant 54. Deux zones entrefers 68, 70 sont délimitées respectivement entre l'électrode interne 64 et la membrane 56 pour la première zone, et l'électrode interne 66 et la membrane 58 pour la seconde zone.

Le dispositif d'excitation/détection électrique 52 comporte un générateur de tension 72, relié, d'une part, au substrat résonnant 54 et, d'autre part, à chaque électrode interne 64, 66, de manière à exercer une excitation électrostatique symétrique sur les deux faces du substrat résonnant 54. Dans ce cas, l'augmentation des forces électrostatiques d'excitation permet une amélioration du couplage électromécanique.

Il est à remarquer que le résonateur 50 peut être vu comme deux résonateurs 10 identiques de la Figure 1 auxquelles les électrodes externes 26 ont été enlevées et dont les faces libres des deux substrats résonnants 18 ont été réunies de façon à un fournir un substrat résonnant 54 commun d'une seul pièce excité selon un mode électrostatique de manière symétrique.

La Figure 3 montre un exemple d'un troisième mode de réalisation 80 d'un résonateur selon l'invention à excitation mono-port dont les éléments communs avec le résonateur 10 de la Figure 1 sont désignés par des références identiques.

Le résonateur 80 comprend un dispositif d'excitation/détection électrique 82 à mode d'excitation mono-port.

Le dispositif d'excitation/détection électrique 82 comprend un générateur de tension 84 connecté d'une part à une électrode interne 86, et d'autre part, à une électrode externe 88, permettant ainsi d'exciter de manière électrostatique les ondes acoustiques de volume dans le substrat résonnant 18.

A l'instar des résonateurs 10, 50 des Figures 1 et 2, le substrat résonnant 18 est ici constitué d'une couche du silicium dopé connu pour être un matériau conducteur.

La zone d'entrefer, ici remplie d'air et désignée par la référence 90, comprise dans une cavité interne recouverte par la membrane 24 et le substrat résonnant 18 permet de réaliser une impédance acoustique de faible valeur, propre à confiner les ondes acoustiques de volume au sein d'une zone vibrante 92, visible sur la figure 3, du substrat résonnant 18.

De plus, ici l'électrode externe 88 est rendue inerte acoustiquement en la faisant reposer dans une zone inerte de la surface du résonateur.

Ainsi, l'énergie emmagasinée dans la zone de propagation des ondes n'est pas rayonnée à l'extérieur, indépendamment du fait que l'excitation soit symétrique ou non.

L'électrode externe 88 est structurée en fonction de la nature du substrat résonnant 18 pour permettre le piégeage des ondes acoustiques de volume par modification locale des conditions aux limites mécaniques. Dans la réalisation de la figure 3, l'électrode externe 88 comporte un trou 94 de manière à favoriser le piégeage acoustique au sein du silicium utilisé comme substrat résonnant 18.

De plus, dans ce mode de réalisation, le via traversant 36 est désaxé par rapport à la zone vibrante 92 et la largeur de la cavité interne est agrandie de manière asymétrique de sorte que la zone vibrante 92 ne se trouve pas en regard du via traversant 36, celui-ci étant ainsi disposé sous une zone non-vibrante afin d'éviter tout contact avec la zone vibrante 92.

Avantageusement, le résonateur 80 selon l'invention comporte un élément de piégeage des ondes de volume dans le substrat résonnant 18, afin d'améliorer le coefficient de qualité du résonateur 80.

De manière plus précise, on modifie la forme du substrat résonnant 18 afin d'optimiser le piégeage des ondes acoustiques de volume au sein du substrat 18. De manière préférée, la couche du substrat résonnant 18 est amincie localement sur une face ou deux faces de manière à obtenir une surface concave de rayon de courbure optimisée. En variante, on effectue une surcharge massique des bords de l'électrode externe 88.

L'utilisation du dispositif d'excitation/détection 82 permet d'appliquer en même temps la tension continue importante, servant à polariser la zone d'entrefer 90 et le signal sinusoïdal à faible tension, servant à entretenir les vibrations autour d'un état d'équilibre.

Le dispositif d'excitation 82 est propre à détecter également les variations du champ électrique généré par la vibration du substrat résonnant 18.

La fréquence de résonance du résonateur 80 est déterminée principalement par l'épaisseur t₁ du substrat résonnant 18 et par les caractéristiques élastiques du matériau du substrat résonnant 18. De manière plus précise, comme chaque matériau possède une vitesse de propagation des ondes acoustiques de volume donné qui est directement liée à la fréquence de résonance, le choix du matériau détermine la fréquence de résonance du résonateur souhaité.

De préférence, le résonateur 80 a une fréquence de résonance comprise entre dix et cent MHz.

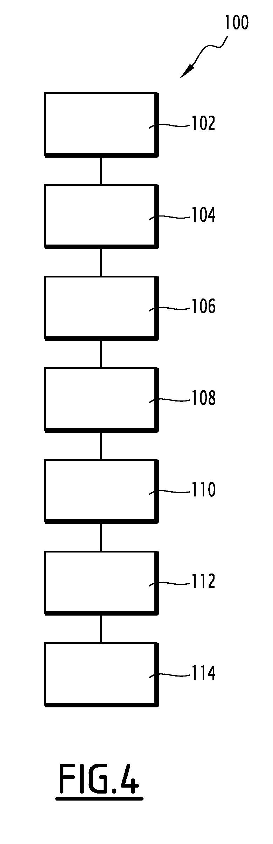

La Figure 4 représente un organigramme d'un procédé de fabrication 100 d'un résonateur 10 selon l'invention.

Dans une première étape 102, il est fourni un support 12 à deux faces constitué par une couche d'une première épaisseur d'un premier matériau. La préparation du support 12 comprend un dépoussiérage, une attaque acide afin de limiter des éléments organiques absorbés et un rinçage. Le matériau du support 12 est compris dans l'ensemble des matériaux constitués par le verre, la céramique, la silice fondue ou un autre matériau isolant.

De préférence, le matériau utilisé est le verre en raison de sa capacité d'isolation électrique, sa stabilité dans le temps, son aptitude à recevoir un dépôt d'électrodes métalliques et à être assemblé avec d'autres matériaux, par exemple par soudage anodique.

Dans une deuxième étape 104, on effectue une gravure du support 12 fourni afin d'obtenir une forme prédéterminée de la cavité interne 28, du via traversant 36, et de l'ouverture externe 38 comme par exemple la forme représentée sur la Figure 1. De manière plus précise, on procède à trois sous-étapes afin d'obtenir un premier orifice borgne, ou ouverture externe 38, sur la première face inférieure 14, un second orifice borgne, ou cavité interne 28, sur la deuxième face supérieure 16 et un troisième orifice traversant, ou via traversant 36.

Lors de la première sous-étape, on effectue un dépôt Cr/Cu, c'est-à-dire Chrome/Cuivre, pleine plaque par pulvérisation cathodique sur la première face 14 inférieure du support 12. Ensuite, une induction résine par centrifugation est mise en oeuvre puis l'utilisation d'un masque avec aligneur simple face permet, après exposition et révélation, de ne garder qu'une portion de la résine déposée de diamètre et d'épaisseur donnés.

Ensuite, on effectue un dépôt de nickel par électroformage puis on enlève la portion de résine. Une gravure ionique réactive profonde DRIE, acronyme de Deep Reactive Ion Etching, est ensuite utilisée afin d'obtenir une ouverture externe 38, sur la première face 14 inférieure du support 12 de profondeur et de diamètres donnés.

De manière préférée, la section transversale de l'ouverture externe 38 obtenue a une forme carrée.

Puis, lors de la deuxième sous-étape, après enlèvement du nickel, du cuivre et du chrome, on effectue un dépôt de résine sur la deuxième face 16 supérieure du support 12. Ensuite, on utilise un masque avec aligneur simple face afin d'enlever, après exposition et révélation, une portion de la résine déposée de diamètre et d'épaisseur donnés. Une gravure ionique réactive RIE, de l'anglais Reactive Ion Etching, permet ensuite d'obtenir une cavité interne 28, sur la deuxième face 16 supérieure du support 12 de profondeur et de diamètre donnés.

Un dépôt de résine est ensuite appliqué afin d'obtenir une protection des deux faces 14, 16 du support 12.

Lors de la troisième sous-étape, un via traversant 36 est pratiqué par usinage ultrasonique de manière à relier les deux cavités 28, 38 à travers leur fond respectif.

Ensuite, après enlèvement de la résine de protection et un étuvage, une étape 106 de métallisation du support 12 est mise en oeuvre afin d'obtenir une électrode mince, ou électrode interne 32, par une métallisation du fond de la cavité interne 28. En outre,, l'ouverture externe 38 et la paroi latérale du via traversant 36 sont métallisées pour faciliter la connexion de l'électrode interne 32 à un dispositif d'excitation externe..

De manière plus précise, une métallisation double face pleine plaque Au/Cr, soit Or/Chrome, est d'abord pratiquée par pulvérisation sur l'ensemble des faces supérieures et inférieures du support 12, et de la paroi latérale du via traversant 36. Puis, après enduction d'une résine positive double face par nébulisation, l'utilisation de masques avec aligneur double face associé à des opérations de révélation et rinçage permet d'obtenir, après gravure humide Au/Cr, l'électrode interne 32 et la piste 40 telle que représentées, par exemple, sur la Figure 1.

Ensuite, il est procédé à un enlèvement de la résine restante puis à un recuit haute température rapide RTA, acronyme de Rapid Thermal Annealing, afin d'obtenir l'état définitif de l'ensemble constitué du support 12 et de l'électrode interne 32.

Dans une étape 108, il est fourni un substrat résonnant 18 à deux faces constitué par une couche d'une deuxième épaisseur d'un deuxième matériau. Le matériau du substrat résonnant 18 est compris dans l'ensemble des matériaux constitués par le Silicium, le niobate de lithium, le quartz, le corindon, par exemple le saphir, et les grenats d'aluminium-yttrium.

De préférence, le matériau utilisé est le silicium en raison de son caractère conducteur ou isolant en fonction du dopage et sa compatibilité avec la réalisation de circuits électroniques.

L'épaisseur du substrat 18 a été préalablement déterminée pour permettre la création et le maintien d'ondes acoustiques à mode longitudinal dans le sens de l'épaisseur vibrant à la fréquence de travail du résonateur 10,

Dans une étape 110, on réalise une membrane constituée par une couche d'une troisième épaisseur d'un troisième matériau, par exemple de la silice, sur une première face du substrat résonnant 18.

De manière plus précise, on commence par réaliser une couche de silice par oxydation thermique sur les deux faces du substrat résonnant 18. Puis, après dépôt d'une résine pour protéger une première face, ou face inférieure, de l'ensemble constitué du substrat résonnant 18 et des couches de silice, on procède à une attaque humide de l'ensemble « substrat résonnant /Couches de silice » de manière à enlever la résine sur la face supérieure. Ainsi, on obtient une membrane 24 sur la face inférieure du substrat résonnant 18.

Dans une étape 112, après un bain avec mélange sulfo-chromique pour le support 12 et le substrat résonnant 18, on procède à un collage de l'ensemble «substrat résonnant 18 / membrane 24 » avec le support 12. De manière plus précise, la face inférieure de l'ensemble « substrat résonnant 18 / membrane 24 » est soudée à la deuxième face 16 supérieure du support 12 en utilisant une soudure anodique pyrex/silicium. On obtient ainsi un entrefer 34 rempli d'air au sein de la cavité interne 28.

Au cours de cette soudure anodique mise en oeuvre par une machine de soudage, on applique une tension élevée, de l'ordre de 900 V, entre l'électrode 26 déposée sur la face supérieure du substrat résonnant 18 et la première face 14 inférieure du support 12. L'électrode interne 32, disposée au fond de la cavité interne 28, est reliée électriquement à la couche métallique 40 déposée dans le via 36, et en particulier au fond de la cavité 38. Tout risque de claquage électrique de l'entrefer d'air à cause de l'application de la tension lors du processus de soudure anodique est écarté du fait que la cavité 38 est en retrait de la face libre 14.

Dans une étape suivante 114, une électrode externe 26 est métallisée sur la seconde face 22, ou face supérieure, du substrat résonnant 14 à l'aide d'un dépôt Al/Cr, c'est-à-dire Aluminium/Chrome.

De manière avantageuse, dans une étape supplémentaire non représentée, l'ouverture externe 38 est bouchée par une plaque de dimensions proches de celles de la cavité 38, de manière à préserver le vide ou empêcher une introduction d'impuretés au sein de la cavité interne 28.

Le contact ohmique entre l'électrode 26 et le substrat résonnant 18 est amélioré par un premier recuit rapide RTA. Ensuite, un second recuit suivi d'un refroidissement lent améliorent les caractéristiques de l'ensemble du résonateur 10. Enfin une découpe à la micro-scie permet d'obtenir un résonateur 10 aux dimensions externes souhaitées.

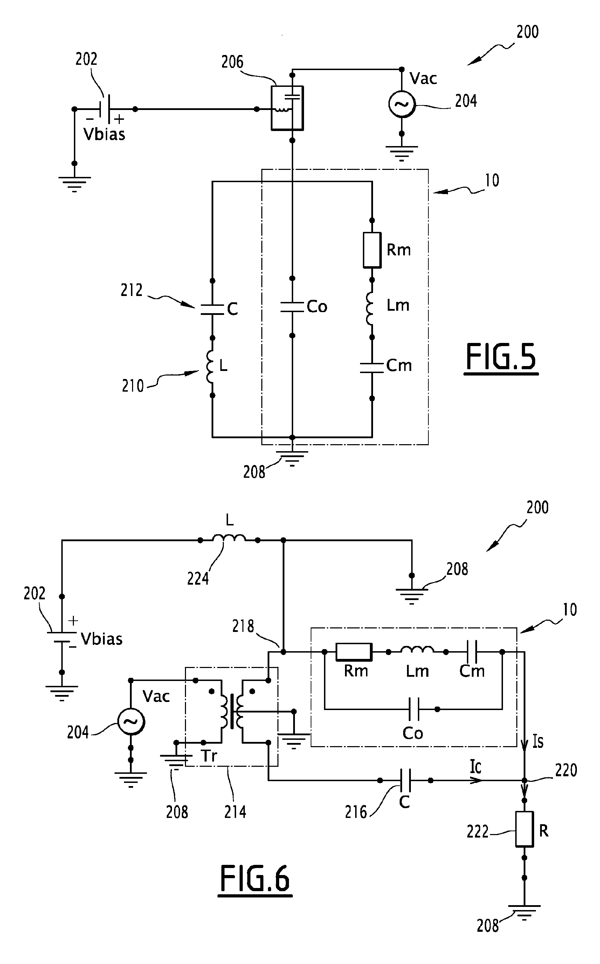

De manière préférée, le résonateur 10 comprend, en outre, un dispositif 200 de compensation de la capacité statique du résonateur 10. Les Figures 5 et 6 représentent deux exemples de réalisation d'un tel dispositif 200, dans lesquels un générateur de tension continue 202 et un générateur de courant alternatif 204 sont propres à appliquer respectivement une tension de polarisation V_{BIAS} et une tension sinusoïdal V_{AC} au niveau du résonateur 10 entre l'électrode interne 32 et l'électrode externe 26.

Le résonateur 10 est représenté par un modèle BVD, c'est-à-dire modèle de Butterworth-Van Dyke, connu de l'homme du métier.

Le modèle BVD définit une capacité statique Co qui représente la capacité statique intrinsèque à la configuration du résonateur 10. Dans l'exemple de réalisation selon l'invention, la capacité statique Co représente essentiellement le gap d'air dans la cavité interne 28 du résonateur 10, associé à la couche de silice de la membrane 24 destinée à réduire la tension de claquage.

Le modèle BVD définit également une branche série comportant trois composantes motionnelles Rm, Lm, Cm, disposée en parallèle de la capacité statique Co. Les trois composantes motionnelles Rm, Lm, Cm représentent respectivement la résistance mécanique du matériau à la vibration acoustique, l'inductance représentative de la masse de matériaux résonnants acoustiquement et une capacité correspondant à l'élasticité du matériau.

A titre d'exemple, la composante Cm a une valeur de quelques fentofarads et la valeur de Co est d'environ 150 à 400 picofarads.

Dans l'exemple de réalisation illustrée sur la Figure 5, le dispositif 200 comporte, en outre, un Té de polarisation 206 connecté en entrée d'une part au générateur de tension continue 202, et d'autre part au générateur de courant alternatif 204. En sortie, le Té de polarisation 206 est relié à une première électrode du résonateur 10 de manière à appliquer, suivant un système type mono-port, à la fois une tension électrique continue et une tension électrique alternative. Dans ce mode de réalisation, le générateur de tension continue 202, le générateur de courant alternatif 204, et le Té de polarisation 206 forment ainsi un dispositif d'excitation électrique 52.

Le résonateur 10 est également relié, de part sa deuxième électrode, à une masse 208. Une branche série, comprenant une self 210 et un condensateur 212, est disposée en parallèle du résonateur 10. La self 210 a une inductance L représentant une inductance de compensation réalisant la relation LCo ω² = 1, où ω désigne la fréquence d'utilisation du dispositif 200.

Comme la valeur de la capacité statique Co est très supérieure à la valeur de Cm, la self 210 permet ainsi de compenser par circuit bouchon LCo la capacité statique Co du résonateur 10. Le condensateur 212 de capacité C permet d'empêcher la self 210 de court-circuiter le générateur de tension continue 202.

Dans l'exemple de réalisation illustrée sur la Figure 6, basée sur un montage de type quadripôle, le dispositif 200 comporte en outre une branche série, comprenant un transformateur 214 à quatre pôles et un condensateur 216, disposée en parallèle du résonateur 10. De manière plus précise, le transformateur 214 est relié, par un premier pôle à un premier noeud 218 connecté à la première électrode du résonateur 10, par un second pôle au condensateur 216, par un troisième pôle à la masse 208, et par un quatrième pôle au générateur de tension alternative 204.

La seconde électrode du résonateur 10 est reliée à un second point milieu 220 connecté d'une part au condensateur 216, et d'autre part à une première borne d'une résistance 222, la seconde borne étant reliée à la masse 208.

Enfin, le noeud 218 est également relié d'une part à la masse 208 et d'autre part à une branche série composée d'une self 224 et du générateur de tension continue 202.

Dans cet exemple de réalisation, le générateur de tension continue 202, le générateur de courant alternatif 204, et la self 224 forment ainsi un dispositif d'excitation électrique 30.

En fonctionnement, le résonateur 10 est propre à générer un courant de sortie Is. L'utilisation du transformateur 214 permet d'injecter dans le courant de sortie Is, un courant Ic en opposition de phase avec le courant traversant Co, ce qui permet de compenser l'effet de la capacité statique Co du résonateur 10 au niveau de la résistance 222.

Ainsi, le dispositif 200 de compensation de la capacité statique permet de diminuer l'effet de la capacité statique Co du résonateur 10, soit par l'utilisation d'une self 210, soit par l'utilisation d'un transformateur 214, de manière à améliorer le couplage électromécanique du résonateur 10.

Afin d'obtenir une réponse électrique du résonateur 10 et de déterminer précisément la fréquence de résonance, on utilise un analyseur de réseau. Par exemple, dans le mode de réalisation illustré sur la figure 5, on remplace le générateur de tension alternative 204 par l'analyseur de réseau pour obtenir la réponse électrique en transmission du résonateur 10. Dans le cas de la figure 6, les deux voies de l'analyseur se substituent au générateur de tension alternative 204 et à la résistance 222 pour une mesure en mode de transmission.

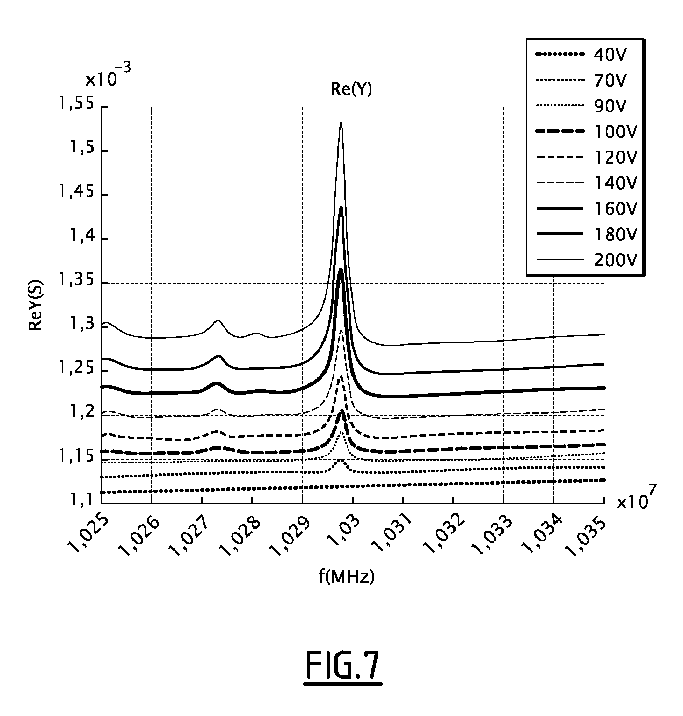

A titre d'exemple, dans le cas d'un substrat résonnant 18 en Silicium, la figure 7 illustre différentes courbes de résonance paramétrée chacune par une valeur de tension de polarisation appliquée comprise entre 40 Volts et 200 Volts.

Chaque courbe de résonance représente une réponse électrique Re(Y) du résonateur 10, et plus précisément l'évolution de sa conductance d'entrée, en fonction de la fréquence du signal d'excitation sinusoïdal. Dans cet exemple, il est clairement visible l'influence de la tension de polarisation sur la qualité de la résonance, la fréquence de résonance étant proche de 10,3 MHz, et la qualité de la résonance pouvant être estimée comme le rapport de la hauteur du lobe de résonance sur sa largeur à un « roll-off » prédéterminé.

Des mesures de coefficient de qualité sur le résonateur 10, selon l'invention, à l'aide d'un analyseur de réseau, permettent de caractériser les vibrations induites par effet électrostatique. Ainsi, le coefficient de qualité mesuré est de l'ordre de 8000, ce qui permet d'obtenir un produit Qf proche de 10¹¹.

Le résonateur selon l'invention est propre à une utilisation pour la fabrication d'un oscillateur électrique.

De manière connue, l'oscillateur se présente sous la forme d'un système bouclé comprenant un élément actif, comme un circuit amplificateur par exemple, et un élément passif comprenant le résonateur. Le système bouclé, opérant à un point de fonctionnement donné, est destiné à réinjecter un signal synchrone à la vibration du résonateur, ce qui permet de compenser des pertes d'insertion inhérentes à toute structure résonnante.

Le résonateur selon l'invention est propre également à une utilisation en tant que filtre, par exemple, par combinaison d'éléments d'impédance ou encore en structure monolithique.

Enfin, le résonateur selon l'invention est propre à une utilisation en tant que capteur. En effet, le résonateur étant sensible aux effets paramétriques, c'est-à-dire aux variations des conditions environnementales de fonctionnement, il est donc propre à une exploitation comme capteur de grandeur physique. A titre d'exemple, les grandeurs physiques sont la température, la pression, l'accélération, ou la masse d'une fine couche déposée sur l'électrode externe 26.

De manière générale, l'invention permet de s'affranchir de l'effet piézoélectrique pour l'excitation d'ondes de volume et permet donc d'exciter directement ces ondes dans tous types de matériaux, et en particulier, dans des matériaux non piézoélectriques.

Cette caractéristique permet de disposer d'un champ de matériaux non limité aux matériaux piézoélectriques. De ce fait, l'invention présente de nombreux avantages en termes de réductions de coût, de taille, et de fonctionnement global des composants concernés grâce notamment à l'amélioration de la co-intégration du résonateur 10 avec les dispositifs électroniques associés, permettant ainsi de minimiser l'hybridation des composants.

## Revendications

1. Résonateur à ondes acoustiques de volume configuré pour résonner à une fréquence de travail prédéterminée comprenant :
- un support (12), comprenant une première face (14) et une deuxième face (16), constitué par une couche d'une première épaisseur (s₁) d'un premier matériau isolant acoustiquement et électriquement,
- un substrat résonnant (18), comprenant une première face (20) et une deuxième face (22), constitué par au moins une couche d'une deuxième épaisseur (t₁) d'un second matériau acoustiquement résonnant, et
- une membrane (24) constituée par une couche d'une troisième épaisseur (m₁) d'un troisième matériau, la membrane (24) reliant rigidement, d'une part, la deuxième face (16) du support (12) et, d'autre part, la première face (20) du substrat résonnant (18),
**caractérisé en ce que**
le support (12) comprend une cavité interne (28) débouchante sur la deuxième face (16) du support (12), ayant une face de plancher (30) située en retrait dans le sens de l'épaisseur du support (12) par rapport à la deuxième face (16) du support (12), et une électrode interne (32) plane métallique, déposée sur la face de plancher (30), de sorte à former une zone d'entrefer (34) entre l'électrode interne (32) et une portion (35) de la membrane (24) disposée en vis-à-vis, et **en ce que**
le substrat résonnant (18) est configuré par le choix de ladite deuxième épaisseur (t₁) de manière à créer un couplage entre un mode électrostatique dans la zone d'entrefer (34) et un mode mécanique d'extension-compression d'une épaisseur du substrat résonant (18) de sorte à générer entre sa première face (20) et sa deuxième face (22) des ondes acoustiques à mode longitudinal vibrant à la fréquence de travail du résonateur, lorsqu'un champ électrostatique ayant une composante différentielle continue de niveau élevée et une composante sinusoïdale à la fréquence de travail est généré dans la zone d'entrefer (34) par application d'une tension différentielle entre, soit la première face (20) du substrat résonnant (18) et l'electrode interne (32) lorsque le substrat résonnant (18) est électriquement conducteur et la membrane (24) est électriquement isolante, soit la membrane (24) et l'électrode interne (32) lorsque le substrat résonnant (18) est électriquement isolant et la membrane (24) est électriquement conductrice.

2. Résonateur à ondes acoustiques de volume selon la revendication 1, **caractérisé en ce que** la cavité interne (28) comporte une arête avec la deuxième face (16) du support (12) ayant un contour qui délimite une zone surfacique de la portion (35) de membrane apte à être déformée dans le sens de l'épaisseur de la membrane (24) lorsqu'un champ électrique est appliqué dans la zone d'entrefer (34).

3. Résonateur à ondes acoustiques de volume selon l'une quelconque des revendications 1 à 2, **caractérisé en ce que** le support (12) comprend un via traversant (36) reliant la cavité interne (28) à une ouverture externe (38), percée sur la première face (14) du support (12), et une piste métallique (40) d'accès, déposée dans une surface interne du via traversant (36) et connectée à l'électrode interne (32) pour faciliter la connexion de l'électrode interne (32) à un dispositif d'excitation externe.

4. Résonateur à ondes acoustiques de volume selon l'une quelconque des revendications 1 à 3, dans lequel une électrode externe (26) métallique est déposée sur la deuxième face (22) du substrat résonnant (18) pour faciliter l'accès électrique d'un dispositif d'excitation à la membrane (24).

5. Résonateur à ondes acoustiques de volume selon l'une quelconque des revendications 1 à 4, **caractérisé en ce que** le second matériau du substrat résonnant (18) est un élément du groupe consistant en du silicium, du saphir, du grenat d'aluminium-ytrium, du niobate de lithium, et du quartz.

6. Résonateur à ondes acoustiques de volume selon l'une quelconque des revendications 1 à 5, **caractérisé en ce que** le troisième matériau de la membrane (24) est un élément du groupe consistant en de la silice, du nitrure de silicium, de l'aluminium, de l'or, du platine, et du tungstène.

7. Résonateur à ondes acoustiques de volume selon la revendication 4, **caractérisé en ce que** le substrat résonnant (18) est un isolant électrique, et **en ce qu'**il comprend une piste de connexion électrique reliant l'électrode externe (26) et la membrane (24), conductrice dans ce cas.

8. Résonateur à ondes acoustiques de volume selon l'une quelconque des revendications 4 à 7, **caractérisé en ce que** l'électrode externe (26) a une forme configurée pour piéger les ondes acoustiques de volume dans une zone vibrante.

9. Résonateur à ondes acoustiques de volume selon la revendication 8" **caractérisé en ce que** la cavité interne (28) a une forme configurée pour que le via traversant (36) soit en regard d'une zone non vibrante et que soit évité tout contact entre le via traversant (36) et la zone vibrante.

10. Résonateur à ondes acoustiques de volume selon l'une quelconque des revendications 1 à 9, **caractérisé en ce que** le premier matériau du support (12) est un matériau compris dans le groupe des matériaux consistant en du verre, de la silice fondue, et de la céramique.

11. Résonateur à ondes acoustiques de volume selon l'une quelconque des revendications 1 à 10, **caractérisé en ce que** le second matériau du substrat résonnant (14) est un matériau non piézoélectrique.

12. Résonateur à ondes acoustiques de volume selon l'une quelconque des revendications 1 à 11, **caractérisé en ce que** le second matériau du substrat résonnant (14) est un matériau monocristallin.

13. Résonateur à ondes acoustiques de volume selon l'une quelconque des revendications 1 à 12, **caractérisé en ce qu'**il comprend
un dispositif (52 ; 82) d'excitation/détection électrique configuré pour créer dans la zone d'entrefer (68, 70 ; 90) et la membrane isolante (56, 58 ; 24) un champ électrique d'excitation électrostatique du substrat résonnant (54 ; 18) à la fréquence de travail, et pour détecter les variations de champ électrique à la fréquence de travail provoquées par les vibrations acoustiques du substrat résonnant (54 ;18), et
un dispositif (200) de compensation d'une capacité statique de l'entrefer comprenant au moins un élément du groupe consistant en : une self, et un transformateur.

14. Procédé de fabrication d'un résonateur (10) à ondes acoustiques de volume conforme à l'une quelconque des revendications 1 à 13, comprenant :
- une étape (102) de fourniture d'un support (12), comprenant une première face (14) et une deuxième face (16), constituant une couche d'une première épaisseur d'un premier matériau,
- une étape (104) de gravure du support (12) de manière à le munir d'une cavité interne (28),
- une étape (106) de métallisation de la cavité interne du support (12) de manière à obtenir une électrode interne (32) dans la cavité interne (28),
- une étape (108) de fourniture d'un substrat résonnant (18), comprenant une première face (20) et une deuxième face (22), constitué par au moins une couche d'une deuxième épaisseur d'un second matériau,
- une étape (110) de réalisation d'une membrane (24) constituée par une couche d'une troisième épaisseur d'un troisième matériau sur une première face (20) du substrat résonnant (18), et,
- une étape (112) de collage de la membrane (24) à la seconde face (16) du support (12).

15. Procédé selon la revendication 14, comportant une étape (114) de métallisation propre à déposer une couche d'un matériau conducteur sur la seconde face (22) du substrat résonnant (18), de manière à former une électrode externe (26).

16. Composant électronique comprenant un résonateur (10 ; 50 ; 80) défini selon l'une quelconque des 1 à 13, **caractérisé en ce que** le composant électronique est un élément du groupe consistant en un oscillateur, un filtre et un capteur.

## Patentansprüche

1. Resonator akustischer Volumenwellen, der konfiguriert ist, um in einer vorbestimmten Arbeitsfrequenz mitzuschwingen, umfassend:
- eine Unterlage (12), die eine erste Fläche (14) und eine zweite Fläche (16) umfasst, die von einer Schicht in einer ersten Dicke (s₁) aus einem ersten akustisch und elektrisch isolierenden Material gebildet ist,
- ein mitschwingendes Substrat (18), das eine erste Fläche (20) und eine zweite Fläche (22) umfasst, das von mindestens einer Schicht in einer zweite Dicke (t₁) aus einem zweiten akustisch mitschwingenden Material gebildet ist, und
- eine Membran (24), die von einer Schicht in einer dritten Dicke (m₁) aus einem dritten Material gebildet ist, wobei die Membran (24) einerseits die zweite Fläche (16) der Unterlage (12) und andererseits die erste Fläche (20) des mitschwingenden Substrats (18) starr verbindet,
**dadurch gekennzeichnet, dass**
die Unterlage (12) einen internen, auf der zweiten Fläche (16) der Unterlage (12) ausmündenden Hohlraum (28) umfasst, mit einer Bodenfläche (30), die sich zurückgenommen in Richtung der Dicke der Unterlage (12) im Verhältnis zur zweiten Fläche (16) der Unterlage (12) befindet, und eine flache metallische interne Elektrode (32), die auf der Bodenfläche (30) derart angeordnet ist, dass eine Spaltzone (34) zwischen der internen Elektrode (32) und einem gegenüberliegenden Abschnitt (35) der Membran (24) gebildet wird, und dass
das mitschwingendes Substrat (18) durch die Wahl der zweiten Dicke (t₁) derart konfiguriert ist, dass eine Kopplung zwischen einem elektrostatischen Modus in der Spaltzone (34) und einem mechanischen Erweiterungs-Kompressions-Modus einer Dicke des mitschwingenden Substrats (18) derart erfolgt, dass zwischen seiner ersten Fläche (20) und seiner zweiten Fläche (22) Akustikwellen im Längsmodus erzeugt werden, die in der Arbeitsfrequenz des Resonators mitschwingen, wenn ein elektrostatisches Feld mit einer kontinuierlichen Differentialkomponente hohen Niveaus und eine Sinuskomponente in Arbeitsfrequenz in der Spaltzone (34) durch Anlegen einer Differentialspannung erzeugt wird zwischen entweder der ersten Fläche (20) des mitschwingenden Substrats (18) und der internen Elektrode (32), wenn das mitschwingende Substrat (18) elektrisch leitend ist und die Membran (24) elektrisch isolierend ist, oder der Membran (24) und der internen Elektrode (32), wenn das mitschwingende Substrat (18) elektrisch isolierend ist und die Membran (24) elektrisch leitend ist.

2. Resonator akustischer Volumenwellen nach Anspruch 1, **dadurch gekennzeichnet, dass** der interne Hohlraum (28) mit der zweiten Fläche (16) der Unterlage (12) eine Kante aufweist, die eine Kontur hat, die eine Oberflächenzone des Abschnitts (35) der Membran bildet, die imstande ist, in Richtung der Dicke der Membran (24) verformt zu werden, wenn ein elektrisches Feld in der Spaltzone (34) angelegt wird.

3. Resonator akustischer Volumenwellen nach einem der Ansprüche 1 bis 2, **dadurch gekennzeichnet, dass** die Unterlage (12) einen Durchgang (36) umfasst, der den internen Hohlraum (28) mit einer externen Öffnung (38) verbindet, die sich auf der ersten Fläche (14) der Unterlage (12) befindet, und einen metallischen Zugangspfad (40), der in einer internen Oberfläche des Durchgangs (36) aufgebracht und mit der internen Elektrode (32) verbunden ist, um die Verbindung der internen Elektrode (32) mit einer externen Erregungsvorrichtung zu erleichtern.

4. Resonator akustischer Volumenwellen nach einem der Ansprüche 1 bis 3,wobei eine metallische externe Elektrode (26) auf der zweiten Fläche (22) des mitschwingenden Substrats (18) aufgebracht ist, um den elektrischen Zugang einer Erregungsvorrichtung auf die Membran (24) zu erleichtern.

5. Resonator akustischer Volumenwellen nach einem der Ansprüche 1 bis 4, **dadurch gekennzeichnet, dass** das zweite Material des mitschwingenden Substrats (18) ein Element der Gruppe ist, die aus Silizium, Saphir, Aluminium-Yttrium-Granat, Lithiumniobat und Quarz besteht.

6. Resonator akustischer Volumenwellen nach einem der Ansprüche 1 bis 5, **dadurch gekennzeichnet, dass** das dritte Material der Membran (24) ein Element der Gruppe ist, die aus Silizium, Siliziumnitrid, Aluminium, Gold, Platin und Wolfram besteht.

7. Resonator akustischer Volumenwellen nach Anspruch 4, **dadurch gekennzeichnet, dass** das mitschwingende Substrat (18) ein elektrischer Isolator ist und dass es einen elektrischen Verbindungspfad umfasst, der die externe Elektrode (26) und die in diesem Fall leitende Membran (24) verbindet.

8. Resonator akustischer Volumenwellen nach einem der Ansprüche 4 bis 7, **dadurch gekennzeichnet, dass** die externe Elektrode (26) eine Form hat, die konfiguriert ist, um die akustischen Volumenwellen in einer Schwingungszone aufzufangen.

9. Resonator akustischer Volumenwellen nach Anspruch 8, **dadurch gekennzeichnet, dass** der interne Hohlraum (28) eine Form hat, die konfiguriert ist, damit sich der Durchgang (36) gegenüber einer nicht schwingenden Zone befindet und jeder Kontakt zwischen dem Durchgang (36) und der Schwingungszone vermieden wird.

10. Resonator akustischer Volumenwellen nach einem der Ansprüche 1 bis 9, **dadurch gekennzeichnet, dass** das erste Material der Unterlage (12) ein Material aus der Materialgruppe ist, die aus Glas, geschmolzenem Silizium und Keramik besteht.

11. Resonator akustischer Volumenwellen nach einem der Ansprüche 1 bis 10, **dadurch gekennzeichnet, dass** das zweite Material des mitschwingenden Substrats (14) ein nicht piezoelektrisches Material ist.

12. Resonator akustischer Volumenwellen nach einem der Ansprüche 1 bis 11, **dadurch gekennzeichnet, dass** das zweite Material des mitschwingenden Substrats (14) ein monokristallines Material ist.

13. Resonator akustischer Volumenwellen nach einem der Ansprüche 1 bis 12, **dadurch gekennzeichnet, dass** er umfasst:
eine elektrische Erregungs-/Erfassungsvorrichtung (52; 82), die konfiguriert ist, um in der Spaltzone (68, 70; 90) und der isolierenden Membran (56, 58; 24) ein elektrisches Feld elektrostatischer Erregung des mitschwingenden Substrats (54; 18) in Arbeitsfrequenz zu erzeugen und um die elektrischen Feldschwankungen in Arbeitsfrequenz, die von den akustischen Schwingungen des mitschwingenden Substrats (54; 18) hervorgerufen werden, zu erfassen, und
eine Ausgleichsvorrichtung (200) einer statischen Kapazität des Spalts, die mindestens ein Element der Gruppe umfasst, die aus einer Selbstinduktionsspule und einem Transformator besteht.

14. Verfahren zur Herstellung eines Resonators (10) akustischer Volumenwellen nach einem der Ansprüche 1 bis 13,das umfasst:
- einen Bereitstellungsschritt (102) einer Unterlage (12), die eine erste Fläche (14) und eine zweite Fläche (16) umfasst, die eine Schicht in einer ersten Dicke eines ersten Materials bildet,
- einen Gravurschritt (104) der Unterlage (12) derart, dass sie mit einem internen Hohlraum (28) ausgestattet wird,
- einen Metallisierungsschritt (106) des internen Hohlraums der Unterlage (12) derart, dass man eine interne Elektrode (32) im internen Hohlraum (28) erhält,
- einen Bereitstellungsschritt (108) eines mitschwingenden Substrats (18), das eine erste Fläche (20) und eine zweite Fläche (22) umfasst, das von mindestens einer Schicht in einer zweiten Dicke eines zweiten Materials gebildet ist,
- einen Realisierungsschritt (110) einer Membran (24), die von einer Schicht in einer dritten Dicke eines dritten Material auf einer ersten Fläche (20) des mitschwingenden Substrats (18) gebildet ist, und
- einen Klebeschritt (112) der Membran (24) auf der zweiten Fläche (16) der Unterlage (12).

15. Verfahren nach Anspruch 14, das einen Metallisierungsschritt (114) umfasst, bei dem eine Schicht eines leitenden Materials auf die zweite Seite (22) des mitschwingenden Substrats (18) derart aufbringbar ist, dass eine externe Elektrode (26) gebildet wird.

16. Elektronische Bauteil, das einen Resonator (10; 50; 80) nach einem der Ansprüche 1 bis 13 umfasst, **dadurch gekennzeichnet, dass** das elektronische Bauteil ein Element der Gruppe ist, die aus einem Oszillator, einem Filter und einem Sensor besteht.

## Claims

1. Acoustic volume wave resonator configured to resonate at a predetermined work frequency comprising:
- a mounting (12), comprising a first surface (14) and a second surface (16), formed by a layer, with a first thickness (s₁), of a first acoustically and electrically insulating material,
- a resonating substrate (18), comprising a first surface (20) and a second surface (22), made up of at least one layer, with a second thickness (t₁), of a second acoustically resonating material, and
- a diaphragm (24), made up of a layer, with a third thickness (m₁), of a third material, the diaphragm (24) rigidly connecting the second surface (16) of the mounting (12) on the one hand and the first surface (20) of the resonating substrate (18) on the other hand,
**characterized in that**
the mounting (12) comprises an internal cavity (28) emerging on the second surface (16) of the mounting (12), having a floor surface (30) set back in the direction of the thickness of the mounting (12) from the second surface (16) of the mounting (12), and a planar metal internal electrode (32), deposited on the floor surface (30), so as to form a gap area (34) between the internal electrode (32) and a portion (35) of the diaphragm (24) facing it, and **in that**
the resonating substrate (18) is configured by the choice of said second thickness (t₁) so as to create a coupling between an electrostatic mode in the gap area (34) and an extension-compression mechanical mode of a thickness of the resonating substrate (18) so as to generate, between its first surface (20) and its second surface (22), longitudinal mode acoustic waves vibrating at the work frequency of the resonator, when an electrostatic field having a differential continuous component of high level and a sinusoidal component at the work frequency is generated in the gap area (34) by applying a differential voltage between either the first surface (20) of the resonating substrate (18) and the internal electrode (32) when the resonating substrate (18) is electrically conductive and the diaphragm (24) is electrically insulating, or the diaphragm (24) and the internal electrode (32) when the resonating substrate (18) is electrically insulating and the diaphragm (24) is electrically conducting.

2. Acoustic volume wave resonator according to claim 1, **characterized in that** the internal cavity (28) includes an edge with the second surface (16) of the mounting (12) having a contour that delimits a surface area of the diaphragm portion (35) that can be deformed in the direction of the thickness of the diaphragm (24) when an electrical field is applied in the gap area (34).

3. Acoustic volume wave resonator according to any one of claims 1 to 2, **characterized in that** the mounting (12) comprises a through via (36) connecting the internal cavity (28) to an external opening (38), pierced on the first surface (14) of the mounting (12), and a metal access track (40), deposited in an internal surface of the through via (36) and connected to the internal electrode (32) to facilitate the connection of the internal electrode (32) to an external excitation device.

4. Acoustic volume wave resonator according to any one of claims 1 to 3, wherein a metallic external electrode (26) is deposited on the second surface (22) of the resonating substrate (18) to facilitate the electrical access of an excitation device to the membrane (24).

5. Acoustic volume wave resonator according to any one of claims 1 to 4, **characterized in that** the second material of the resonating substrate (18) is an element from the set of materials made up of silicon, sapphire, aluminum-yttrium garnet, lithium niobate, and quartz.

6. Acoustic volume wave resonator according to any one of claims 1 to 5, **characterized in that** the third material of the diaphragm (24) is an element from the group consisting of silica, silicon nitride, aluminum, gold, platinum, and tungsten.

7. Acoustic volume wave resonator according to claim 4, **characterized in that** the resonating substrate (18) is an electrical insulator, and **in that** it comprises an electrical connection line connecting the external electrode (26) and the diaphragm (24), which is conductive in this case.

8. Acoustic volume wave resonator according to any one of claims 4 to 7, **characterized in that** the external electrode (26) has a shape configured to trap the acoustic volume waves in a vibrating area.

9. Acoustic volume wave resonator according to claim 8, **characterized in that** the internal cavity (28) has a shape configured so that the through via (36) is across from a non-vibrating area and all contact between the through via (36) and the vibrating area is avoided.

10. Acoustic volume wave resonator according to any one of claims 1 to 9, **characterized in that** the first material of the mounting (12) is a material comprised in the group of materials consisting of glass, molten silica, and ceramic.

11. Acoustic volume wave resonator according to any one of claims 1 to 10, **characterized in that** the second material of the resonating substrate (14) is a non-piezoelectric material.

12. Acoustic volume wave resonator according to any one of claims 1 to 11, **characterized in that** the second material of the resonating substrate (14) is a monocrystalline material.

13. Acoustic volume wave resonator according to any one of claims 1 to 12, **characterized in that** it comprises
an electrical excitation/detection device (52; 82) configured to create, in the gap area (68, 70 ; 90) and the insulating diaphragm (56, 58; 24), an electrical electrostatic excitation field of the resonating substrate (54 ; 18) at the work frequency, and to detect the electrical field variations at the work frequency caused by the acoustic vibrations of the resonating substrate (54 ; 18), and
a device (200) for compensating a static capacity of the gap comprising at least one element from the group consisting of: an induction coil and a transformer.

14. Method for manufacturing an acoustic volume wave resonator (10) according to any one of claims 1 to 13, comprising:
- a step (102) for providing a mounting (12), comprising a first surface (14) and a second surface (16), constituting a layer with a first thickness of a first material,
- a step (104) for etching the mounting (12) so as to provide it with an internal cavity (28),
- a step (106) for metallizing the internal cavity of the mounting (12) so as to obtain an internal electrode (32) in the internal cavity (28),
- a step (108) for providing a resonating substrate (18), comprising a first surface (20) and a second surface (22), made up of at least one layer of a second thickness of a second material,
- a step (110) for producing a diaphragm (24) formed by a layer of a third thickness of a third material on a first surface (20) of the resonating substrate (18), and
- a step (112) for gluing the diaphragm (24) to the second surface (16) of the mounting (12).

15. Method according to claim 14, including a metallization step (114) capable of depositing a layer of a conductive material on the second surface (22) of the resonating substrate (18), so as to form an external electrode (26).

16. Electronic component comprising a resonator (10 ; 50 ; 80), said resonator being defined according to any one of claims 1 to 13, **characterized in that** the electronic component is an element from the group consisting of an oscillator, a filter and a sensor.
